# DEMANDE DE BREVET EUROPEEN

(11) **EP 0 676 340 A1**
(43) Date de publication de la demande: **11.10.1995**
(21) Numéro de dépôt: 95400765.4
(22) Date de dépôt: 06.04.1995
(51) Int. Cl.: B65D 81/30, H05K 9/00

(54) **Procédé pour réaliser un boîtier en matière plastique comportant une isolation éléctromagnétique de sa cavité intérieure**

(30) Priorité: 06.04.1994 FR 9404014
(71) Demandeur: COMPAGNIE PLASTIC OMNIUM, F-69007 Lyon (FR)
(72) Inventeur: Uytterhaeghe, Luc, F-01100 Oyonnax (FR)
(74) Mandataire: Nony, Michel

(57) **Abrégé**

Procédé pour réaliser un boîtier comportant une isolation électromagnétique de sa cavité intérieure, constitué par au moins une première et une seconde parties réunies par leurs bords de raccordement, chaque partie comprenant une nappe continue d'un matériau conducteur.

On utilise une première partie (1) du boîtier qui comporte une rainure (6) le long de son bord de raccordement (5) et une seconde partie (2) du boîtier qui comporte une languette (8) le long de son bord de raccordement (7), la périphérie de la nappe de matériau conducteur (3,4) dépassant de la première (1) et de la seconde (2) parties du boîtier, et pour assembler les deux parties (1,2) du boîtier, on engage les périphéries des nappes de matériau conducteur (3,4) dans la rainure (6) de la première partie (1) du boîtier et l'on engage la languette (8) dans ladite rainure (6) en assurant ainsi la continuité des deux nappes de matériau conducteur (3,4).

Boîtier comportant une isolation électromagnétique.

## Description

La présente invention concerne un procédé pour réaliser un boîtier en matière plastique comportant une isolation électromagnétique de sa cavité intérieure, qui est notamment destiné à contenir un appareil électronique.

Pour réaliser une isolation électromagnétique dans un boîtier non conducteur en matière plastique, une technique connue consiste à incorporer une nappe d'un matériau conducteur dans la paroi du boîtier en surmoulant ladite nappe.

Cette technique donne en général des résultats satisfaisants.

Toutefois, dans le cas où le boîtier est constitué par au moins deux parties distinctes réunies l'une à l'autre par leurs bords de raccordement, l'écran électromagnétique formé par les nappes de matériau conducteur incorporées dans chacune des deux parties du boîtier risque de présenter une discontinuité dans leur zone de raccordement.

En effet, les deux nappes conductrices se rejoignent dans cette zone en étant au mieux pincées entre les bords opposés des deux parties du boîtier, sans garantie d'un bon contact entre lesdites nappes.

Il peut en résulter des fuites vers l'extérieur du boîtier du rayonnement électromagnétique émis par l'appareillage électronique enfermé dans le boîtier ou, inversement, une perturbation du fonctionnement de l'appareillage électronique par un champ électromagnétique régnant à l'extérieur du boîtier.

GB-A-2.217.304 décrit un boîtier comprenant une isolation électromagnétique de sa cavité intérieure, constitué par au moins une première et une seconde parties réunies par leurs bords de raccordement, chaque partie comprenant une nappe continue d'un matériau conducteur, la première partie du boîtier comportant une rainure le long de son bord de raccordement et la seconde partie du boîtier comportant une languette le long de son bord de raccordement. Un tel boîtier nécessite la présence d'un joint élastique au fond de la rainure, ce joint étant recouvert d'une couche conductrice. Il en résulte un problème de complexité de réalisation et de prix de revient élevé.

La présente invention vise à fournir un procédé simple et économique pour réaliser un boîtier à isolation électromagnétique en plusieurs parties qui ne présente pas les inconvénients rappelés ci-dessus.

La présente invention a pour objet un procédé pour réaliser un boîtier comportant une isolation électromagnétique de sa cavité intérieure, constitué par au moins une première et une seconde parties réunies par leurs bords de raccordement, chaque partie comprenant une nappe continue d'un matériau conducteur, procédé selon lequel on utilise une première partie du boîtier qui comporte une rainure le long de son bord de raccordement et une seconde partie du boîtier qui comporte une languette le long de son bord de raccordement, caractérisé par le fait que la périphérie de la nappe de matériau conducteur dépasse de la première et de la seconde parties du boîtier, et que, pour assembler les deux parties du boîtier, on engage les périphéries des nappes de matériau conducteur dépassant des parties du boîtier dans la rainure de la première partie du boîtier et l'on engage la languette dans ladite rainure en assurant ainsi la continuité des deux nappes de matériaux conducteurs.

Selon l'invention, les nappes de matériau conducteur sont mises en contact électrique par leurs périphéries qui se trouvent entremêlées et comprimées l'une contre l'autre à l'intérieur de la rainure de la première partie du boîtier.

La nappe de matériau conducteur peut être, selon un premier mode de mise en oeuvre de l'invention, appliquée contre l'une des faces, de préférence la face intérieure, de chaque partie du boîtier et maintenue en place par collage, rivetage ou tout autre moyen de fixation connu.

Selon un second mode de mise en oeuvre de l'invention, la nappe de matériau conducteur est incorporée dans l'épaisseur de chaque partie du boîtier.

Une variante préférée de ce mode de mise en oeuvre consiste à réaliser chaque partie du boîtier en surmoulant une matière plastique sur la nappe de matériau conducteur, en prenant soin de laisser dépasser de chaque partie du boîtier la périphérie de la nappe.

A cet effet, on place dans un moule ouvert une nappe de matériau conducteur dont la périphérie dépasse du moule et l'on apporte de la matière plastique dans le moule.

Selon cette variante préférée, chaque nappe de matériau conducteur est maintenue en place à l'intérieur du moule par immobilisation de sa périphérie qui est pincée dans le plan de joint du moule lorsque ce dernier se referme.

La matière plastique peut être apportée par injection dans le moule refermé sur la nappe de matériau conducteur, ou déposée dans le moule ouvert, par exemple sous la forme d'un extrudat ou d'une ou plusieurs galettes préchauffées.

On peut également recourir à la technique dite d'injection-compression, laquelle consiste à injecter de la matière plastique dans le moule semi-ouvert et à refermer le moule pour le remplir complètement par fluage de la matière plastique.

Avantageusement, chaque nappe de matériau conducteur est grossièrement préformée avant d'être placée dans le moule correspondant.

La présente invention a également pour objet un boîtier comportant une isolation électromagnétique de sa cavité intérieure, constitué par au moins une première et une seconde parties réunies par leurs bords de raccordement, chaque partie comprenant une nappe continue d'un matériau conducteur, la première partie du boîtier comportant une rainure le long de son bord de raccordement et la seconde partie du boîtier comportant une languette le long de son bord de raccordement, caractérisé par le fait que la périphérie de la nappe de matériau conducteur dépasse de la première et de la seconde parties du boîtier, à l'état désassemblé du boîtier, et que les périphéries des nappes de matériau conducteur dépassant ainsi des parties du boîtier sont engagées dans la rainure de la première partie du boîtier, où elles sont emprisonnées par la languette de la seconde partie du boîtier, à l'état assemblé du boîtier.

Dans le but de mieux faire comprendre l'invention, on va en décrire maintenant un mode de mise en oeuvre donné à titre d'exemple non limitatif en référence au dessin annexé dans lequel :
- la figure 1 représente une section d'un boîtier obtenu par exécution d'un mode de mise en oeuvre du procédé selon l'invention, avant assemblage de ses deux parties constitutives,
- la figure 2 est une vue du détail II de la figure 1,
- la figure 3 est une vue analogue à la figure 2 après assemblage des deux parties du boîtier,
- la figure 4 est une demi-section d'un moule permettant la réalisation de la partie supérieure du boîtier de la figure 1, et
- la figure 5 est une demi-section d'un moule permettant la réalisation de la partie inférieure du boîtier de la figure 1.

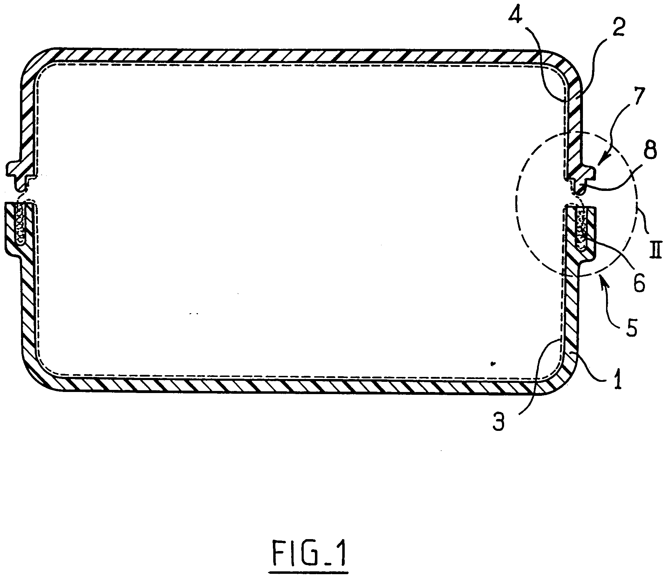

Sur la figure 1, on a représenté une section d'un boîtier comportant une première partie 1 et une seconde partie 2.

Chaque partie 1, 2 est issue du moulage d'une matière plastique.

Une nappe 3 de matériau conducteur, constituée ici par un tissu métallique, est noyée dans la paroi de la première partie 1 du boîtier et apparaît à effleurement de sa face intérieure.

De façon similaire, une nappe 4 du même matériau conducteur apparaît sur la face intérieure de la seconde partie 2 du boîtier.

Conformément à l'invention, la première partie 1 du boîtier comporte un bord de raccordement 5 avec la seconde partie 2 du boîtier, présentant une rainure 6 dirigée vers le haut dans la position du boîtier représenté sur la figure 1.

La rainure 6 s'étend continûment sur toute la périphérie du boîtier.

De même, la seconde partie 2 du boîtier comporte un bord de raccordement 7 avec la première partie 1 du boîtier, présentant une languette 8 dirigée vers le bas par rapport à la figure 1.

La languette 8 s'étend continûment sur toute la périphérie du boîtier et est apte à pénétrer dans la rainure 6.

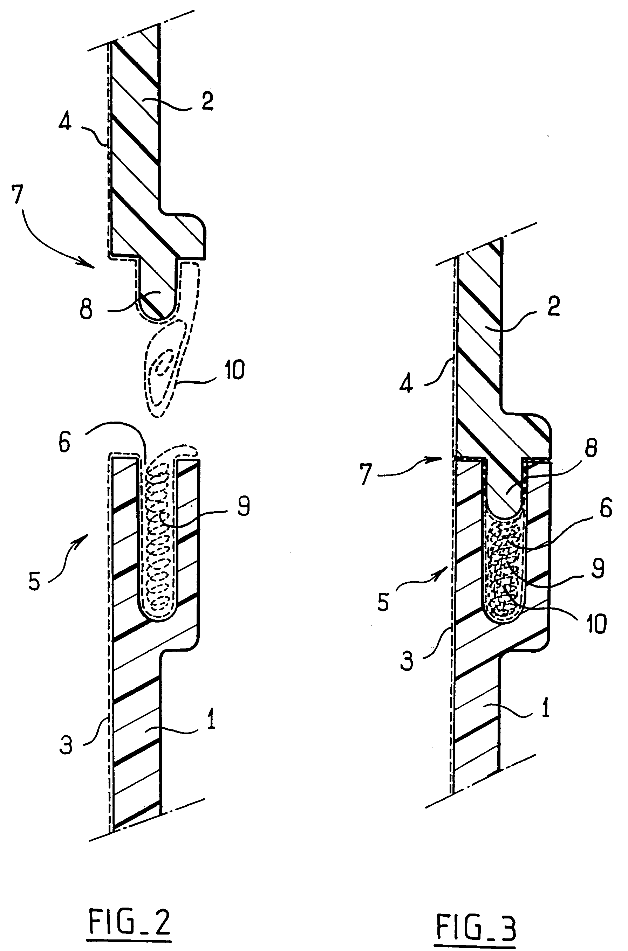

Sur la vue de détail de la figure 2, on voit que la périphérie non surmoulée du tissu métallique 3 est rabattue et accumulée à l'intérieur de la rainure 6 où elle forme un enchevêtrement 9, tandis que la périphérie non surmoulée du tissu métallique 4 est rassemblée sous la forme d'un enroulement aplati 10, dans le prolongement de la languette 8.

De cette manière, lors du rapprochement des deux parties 1 et 2 du boîtier, comme illustré à la figure 3, les deux périphéries 9 et 10 du tissu métallique s'entremêlent à l'intérieur de la rainure 6 où elles sont comprimées l'une contre l'autre.

Ainsi, un bon raccordement électrique est garanti entre le tissu métallique 3 et le tissu métallique 4, sur toute la périphérie du boîtier.

En d'autres termes, l'isolation électromagnétique du boîtier ne présente aucune discontinuité dans le plan de raccordement entre sa première partie 1 et sa seconde partie 2.

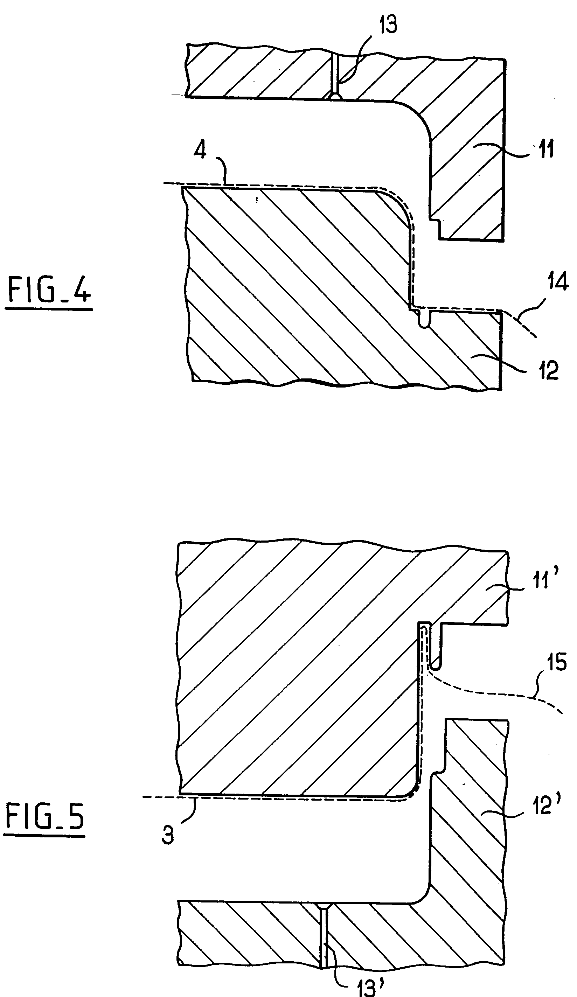

Sur les figures 4 et 5, on a représenté des demi-sections de moules permettant respectivement la réalisation des parties 2 et 1 du boîtier, par injection de matière plastique.

Le moule de la figure 4 comporte deux parties 11 et 12.

Préalablement à l'injection de la matière plastique, par des canaux d'injection 13, on place, contre la partie 12 du moule, le tissu métallique 4 qui a été formé de manière appropriée.

Sur cette figure, on voit clairement que le maintien en position du tissu métallique 4 est assuré par le fait que ce dernier comporte une bande périphérique 14 qui dépasse du moule et se trouve pincée dans le plan de joint du moule lorsque ce dernier est refermé.

Cette bande 14, une fois rabattue et ramenée sensiblement dans le prolongement de la languette 8 constitue l'enroulement aplati 10 de la figure 2.

Sur la figure 5, on a représenté de façon similaire un moule comportant deux parties 11' et 12' pour la réalisation de la première partie 1 du boîtier.

Le tissu métallique 3, préalablement formé de manière appropriée, est disposé contre la partie 11' du moule, avant injection de la matière plastique par des canaux d'injection 13'.

Comme expliqué précédemment, une bande périphérique 15 du tissu métallique 3 dépasse du moule et constitue l'enchevêtrement 9 de la figure 2.

Il est bien entendu que le mode de mise en oeuvre qui vient d'être décrit ne présente aucun caractère limitatif et qu'il pourra recevoir toute modification désirable sans sortir pour cela du cadre de l'invention.

## Revendications

**1 -** Procédé pour réaliser un boîtier comportant une isolation électromagnétique de sa cavité intérieure, constitué par au moins une première (1) et une seconde (2) parties réunies par leurs bords de raccordement (5,7), chaque partie comprenant une nappe continue d'un matériau conducteur (3,4), selon lequel on utilise une première partie (1) du boîtier qui comporte une rainure (6) le long de son bord de raccordement (5) et une seconde partie (2) du boîtier qui comporte une languette (8) le long de son bord de raccordement (7), caractérisé par le fait que la périphérie de la nappe de matériau conducteur (3,4) dépasse de la première (1) et de la seconde (2) parties du boîtier, et que, pour assembler les deux parties (1,2) du boîtier, on engage les périphéries (14,15) des nappes de matériau conducteur (3,4) dépassant des parties du boîtier dans la rainure (6) de la première partie (1) du boîtier et l'on engage la languette (8) dans ladite rainure (6) en assurant ainsi la continuité des deux nappes de matériau conducteur (3,4).

**2 -** Procédé selon la revendication 1, caractérisé par le fait que l'on incorpore la nappe de matériau conducteur (3,4) dans l'épaisseur de chaque partie (1,2) du boîtier par surmoulage d'une matière plastique sur la nappe (3,4) de matériau conducteur, en laissant dépasser de chaque partie (1,2) du boîtier, la périphérie (14,15) de la nappe (3,4).

**3 -** Procédé selon la revendication 2, caractérisé par le fait que chaque nappe de matériau conducteur (3,4) est maintenue en place à l'intérieur du moule par immobilisation de sa périphérie (14,15) qui est pincée dans le plan de joint du moule (11,12,11',12') lorsque ce dernier se referme.

**4 -** Boîtier comportant une isolation électromagnétique de sa cavité intérieure, constitué par au moins une première partie (1) et une seconde partie (2), réunies par leurs bords de raccordement (5,7), chaque partie comprenant une nappe continue d'un matériau conducteur (3,4), la première partie (1) du boîtier comportant une rainure (6) le long de son bord de raccordement (5) et la seconde partie (2) du boîtier comportant une languette (8) le long de son bord de raccordement (7), caractérisé par le fait que la périphérie de la nappe de matériau conducteur (3,4) dépasse de la première et de la seconde parties du boîtier (1,2), à l'état désassemblé du boîtier, et que les périphéries des nappes de matériau conducteur (3,4) dépassant ainsi des parties (1,2) du boîtier sont engagées dans la rainure (6) de la première partie (1) du boîtier où elles sont emprisonnées par la languette (8) de la seconde partie (2) du boîtier, à l'état assemblé du boîtier.
